Europäisches Patentamt

European Patent Office

Office européen des brevets

(11) Publication number: 0 278 034

A1

(12) **EUROPEAN PATENT APPLICATION**

(21) Application number: 87101887.5

(22) Date of filing: 11.02.87

(51) Int. Cl.⁴ G01T 1/28 , H01J 49/02

(43) Date of publication of application:
17.08.88 Bulletin 88/33

(84) Designated Contracting States:
DE GB

(71) Applicant: SHIMADZU CORPORATION
1, Nishinokyo-Kuwabaracho
Nakagyo-ku Kyoto-shi Kyoto 604(JP)

(72) Inventor: Takeda, Takehiro
2-1, 9-701, Oenishishinbayashicho
Nishikyoku
Kyotoshi Kyoto 610-11(JP)
Inventor: Shimazu, Kozo
38, Kamiikedacho, Kitashirakawa Sakyoku
Kyotoshi Kyoto 606(JP)
Inventor: Kuratani, Yuichi
18, Saiinshun-eicho Ukyoku
Kyotoshi Kyoto 615(JP)
Inventor: Miseki, Kozo
4-103, 1-1, 4-chome, Oekitafukunishicho
Nishikyoku
Kyotoshi Kyoto 610-11(JP)
Inventor: Kubodera, Toshiya
1-705, c/o Yuni-Ujigawa Mansion 33,
Nishinaka
Kowata Ujishi Kyoto 611(JP)

(74) Representative: Patentanwälte TER MEER -
MÜLLER - STEINMEISTER
Mauerkircherstrasse 45
D-8000 München 80(DE)

(54) **Detector of charged particles.**

(57) A detector for detecting charged particles comprises a secondary electron multiplier (14) for converting the charged particles into secondary electrons and amplifying the secondary electrons, a scintillator (22) for converting the secondary electrons generated from the secondary electron multiplier (14) into light, and a photomultiplier (30) for receiving the light.

## DETECTOR OF CHARGED PARTICLES

The present invention relates to a detector of charged particles such as plus or minus ions useful for a mass spectrometer or the like.

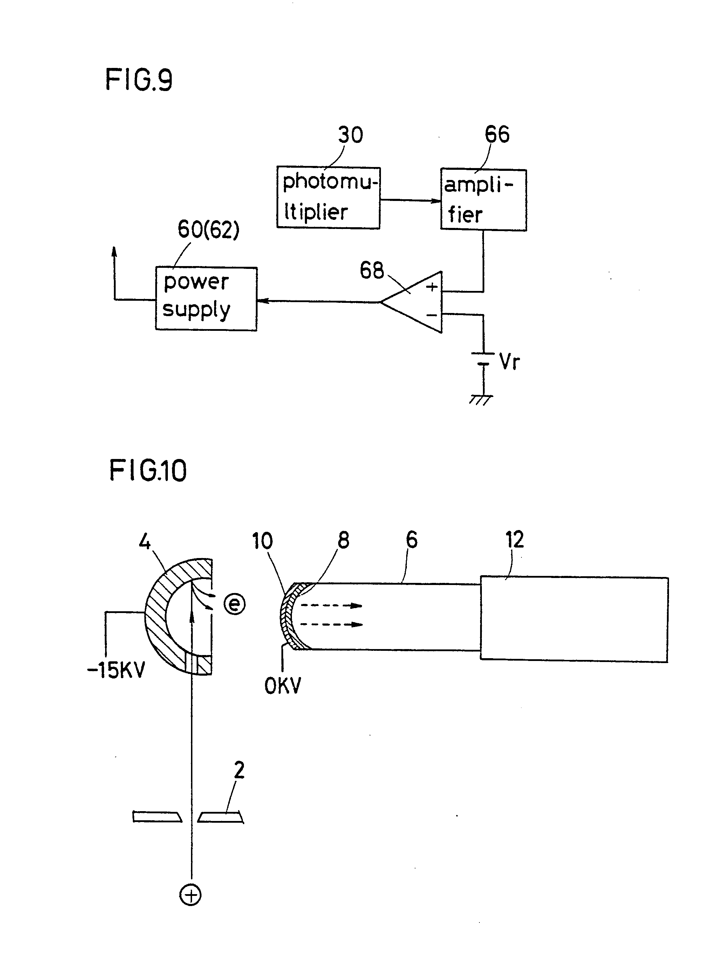

In the usual mass spectrometer, a secondary electron multiplier tube is widely used as a detector for detecting charged particles. As shown in FIG. 10, the Daly-type secondary electron detector is also used. With reference to FIG. 10, a collector slit 2 of a mass spectrometer and an ion-electron converter 4 are provided. To detect plus ions by using the Daily-type detector, a negative high voltage of, e.g. -20KV is supplied to the ion-electron converter 4 so that ions passing through the collector slit 2 collide against the ion-electron converter 4 to thereby generate secondary electrons from the surface of the ion-electron converter 4. An optical guide 6 is positioned at an end of which a scintillator 8 is provided. A thin film 10 on the surface of the scintillator 8 is made by evaporating aluminum. A photomultiplier tube 12 is provided at the other end of the optical guide 6. The scintillator 8 in the optical guide 6 is opposed to the ion-electron converter 4. A high voltage is supplied to the metal film 10 of the scintillator 8 so that the voltage of the metal film 10 is higher (e.g. in the ground voltage) than that of the ion-electron converter 4.

Electrons emitted from the ion-electron converter 4 collide against the scintillator 8 owing to the electric field between the ion-electron converter 4 and the scintillator 8. Then light is emitted from the scintillator 8 and passes through the optical guide 6 up to the photomultiplier tube 12 to be thereby detected by the tube 12.

It is reported in MASS SPECTROSCOPY, vol. 33, No. 2, pp.145 - 147 (1985) that a secondary electron multiplier tube is further interposed between a collector slit and a secondary electron multiplier tube so that ions passing through the collector slit are accelerasted by the interposed secondary electron multiplier tube, thereby enhancing sensitivity in a detector. It is further reported that detection sensitivity becomes about three times as large as a detector simply with the conventional secondary electron multiplier tube.

However, in the conventional detector, measurements for biochemicals and environmental pollutants are impossible with regards to its detection sensitivity less than pg/1$\mu l$. As a voltage applied to a dynode is increased, the gain is also increased. However, together with the signals, noise is also amplified not to thereby improve an S/N ratio and detection sensitivity.

It is an object of the present invention to provide an improved detector providing high detection sensitivity as compared to a conventional secondary electron multiplier tube up to about ten times as great as the conventional case.

Other objects and further scope of applicability of the present invention will become apparent from the detailed description given hereinafter. It should be understood, however, that the detailed description and specific examples, while indicating preferred embodiments of the invention, are given by way of illustration only, since various changes and modifications within the spirit and scope of the invention will become apparent to those skilled in the art from this detailed description.

Pursuant to a preferred embodiment of the present invention, a detector comprises multiplier means for converting incident particles to secondary electrons and multiplying the secondary electrons, scintillator means for converting the secondary electrons, emitted from last-stage dynode means and passing through an exit, into light, and photomultiplier tube means for receiving the light from the scintillator means.

The present invention will become more fully understood from the detailed description given hereinbelow and the accompanying drawings which are given by way of illustration only, and thus are not limitative of the present invention and wherein:

FIG. 1 is a cross-sectional view of a detector according to a first preferred embodiment of the present invention;

FIG. 2 is a cross-sectional view of a mass spectrometer utilizing the detector of FIG. 1 to detect plus ions;

FIG. 3 is a cross-sectional view of a mass spectrometer utilizing the detector of FIG. 1 to detect minus ions;

FIG. 4 is a cross-sectional view of a detector according to a second preferred embodiment of the present invention;

FIG. 5(A) is a cross-sectional view of a detector according to a third preferred embodiment of the present invention;

FIG. 5(B) is a right side view of the detector of FIG. 5(A);

FIG. 6 is a cross-sectional view of a detector according to a fourth preferred embodiment of the present invention;

FIG. 7 is a block diagram of a circuit for enlarging strength measurement region according to a fifth preferred embodiment;

FIG. 8 is a flow chart explaining the operation of the circuit of FIG. 7;

FIG. 9 is a block diagram of a circuit for enlarging intensity measurement region according to a sixth preferred embodiment;

FIG. 10 is a cross-sectional view of a conventional detector; and

FIGS. 11(A) and 11(B) are data obtained according to mass fragmentgraphy (MF) method in gas chromatography and mass spectrometry (GC/MS), FIG. 11(A) relating to the conventional detector and FIG. 11(B) relating to a detector of the present invention (The scale is arbitrary in the above drawings).

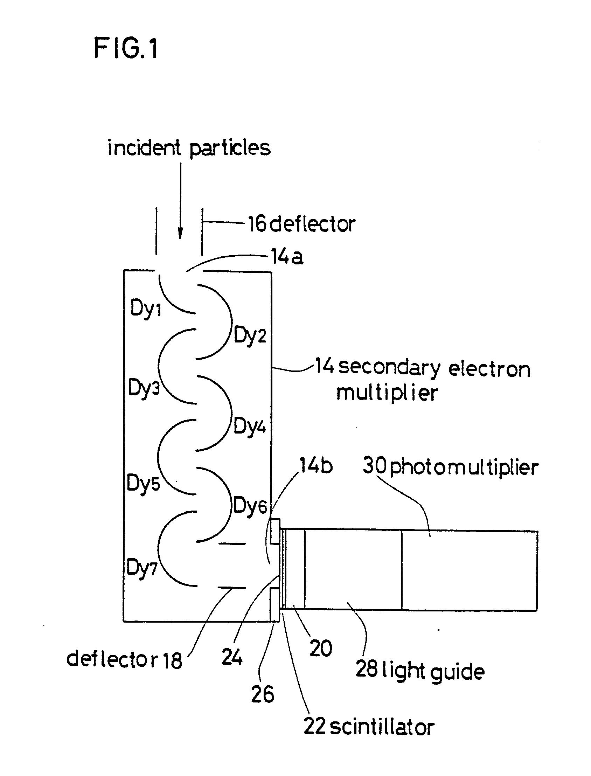

FIG. 1 shows a detector according to a first preferred embodiment of the present invention. A secondary electron multiplier 14 is provided as a multiplier device. Within the multiplier 14, seven-stage dynodes $Dy_1$ through $Dy_7$ are in turn disposed from an entrance 14a, through which charged particles are passed, to an outlet 14b, through which secondary electrons are emitted. Appropriate voltages are applied to the dynodes $Dy_1$ through $Dy_7$ so as to accelerate the secondary electrons emitted from each of the dynode. The material of the dynodes $Dy_1$ through $Dy_7$ is selected to emit the secondary electrons at a high efficiency, stably. For example, Cu-Be alloy, a Cu thin plate on the surface of which Be is evaporated, or Ag - Mg may be used.

The secondary electron multiplier 14 is shielded so as not to decrease an S/N ratio even if scattering ions invade the dynodes $Dy_1$ through $Dy_7$. A deflector 16 is disposed near to the entrance 14a of the multiplier 14. The deflector 16 serves to deflect the direction of charged particles passing through the entrance 14a and being incident upon the first-stage dynode $Dy_1$ of the multiplier 14. Another deflector 18 is disposed between the last-stage dynode $Dy_7$ and an exit 14b of the multiplier 14. The deflector 18 serves to deflect the direction of the secondary electrons emitted from the dynode $Dy_7$ so as to introduce the secondary electrons efficiently into a scintillator 22.

The scintillator 22 is positioned adjacent the exit 14b of the multiplier 14. The scintillator 22 is formed at the surface of a material, for example, a glass plate 20. A metal layer 24 is formed on the surface of the scintillator 22. The metal layer 24 may be an aluminum thin film. The scintillator 22 having the metal layer 24 is provided adjacent the exit 14b of the multiplier 14 and is confronted with the exit 14b. The scintillator 22 is integrally combined with the multiplier 14 with a dielectric material 26. The scintillator 22 may be a well-known material, for example, the fluorescence subject $Y_3Al_5O_{12}$ ; Ce of P46 in RMA. A photomultiplier 30 is disposed via a light guide 28 at a surface opposped to the glass plate 20 with the scintillator 22. The light guide 28 may comprise a synthetic resin or quartz glass to transmit light effectively.

When charged particles or neutral particles are incident upon the first-stage dynode $Dy_1$ of the secondary electron multiplier 14, the dynode $Dy_1$ emits secondary electrons which are multiplied by the second-stage dynode $Dy_2$. The multiplied secondary electrons are further multiplied by the thrid-stage dynode $Dy_3$. Further, the secondary electrons are multiplied by the dynodes $Dy_4$, $Dy_5$, $Dy_6$, and $Dy_7$, subsequently, so that the secondary electrons emitted from the last-stage dynode $Dy_7$ are incident on the scintillator 22. Light caused by the scintillator 22 is introduced into the photomultiplier 30 via the light guide 28 and detected by the photomultiplier 30.

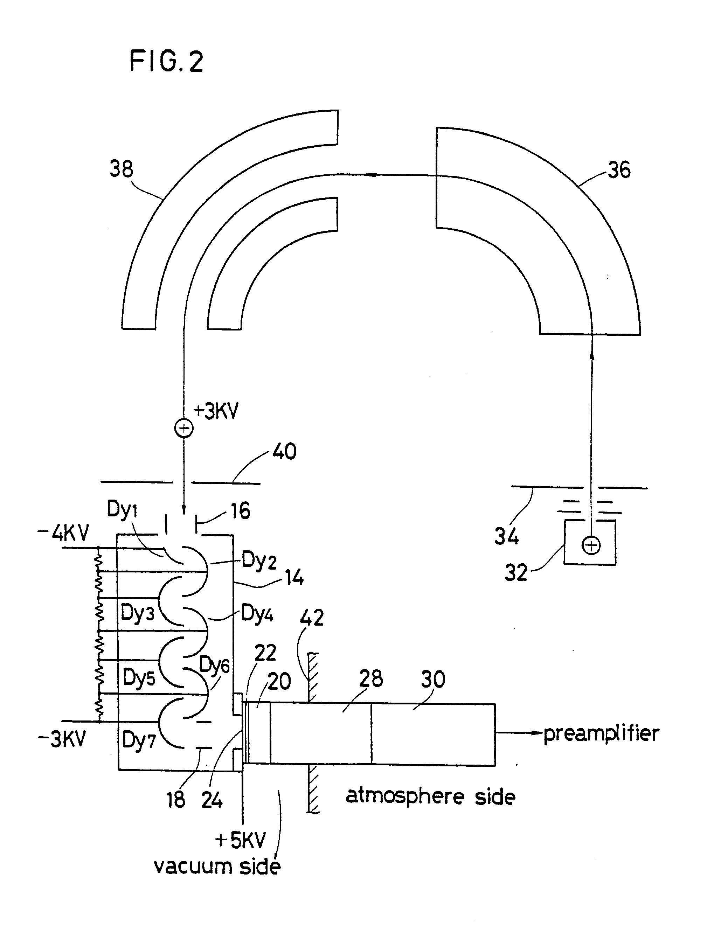

FIG. 2 shows a mass spectrometer utilizing the detector of FIG. 1 to detect plus ions.

The mass spectrometer of FIG. 2 comprises an ion source 32, an ion source slit 34, a electromagnet 36 providing a magnetic field, an electrode 38 offering an electric field, and a collector slit 40. Ions passing through the collector slit 40 are introduced into a first-stage dynode $Dy_1$ of the secondary electron multiplier 14 by the deflector 16.

The combined portion of the secondary electron multiplier 14 and the scintillator 22 is positioned at a vacuum side of the mass spectrometer while the photomultiplier 30 is positioned at an atmosphere side. A side wall 42 of a vacuum apparatus of the mass spectrometer is provided. The light guide 28 is embedded into the side wall 42 so that it connects the scintillator 22 within the vacuum apparatus with the photomultiplier 30 at the atmosphere side. The output signals of the photomultiplier 30 are introduced into a preamplifier to process the signals.

When the plus ions are detected, exemplary voltages applied to the dynodes $Dy_1$ through $Dy_7$ of the secondary electron multiplier and the scintillator 22 are as follows: An acceleration voltage of the mass spectrometer is assumed to be +3KV. A voltage applied to the first-stage dynode $Dy_1$ is -4KV and a voltage applied to the last-stage dynode $Dy_7$ is -3KV. To the intermediate dynodes $Dy_2$ through $Dy_6$, voltages divided with the resistances as shown in FIG. 2 are applied. A voltage of +5KV is applied to the scintillator 22 through the metal layer 24 at the surface.

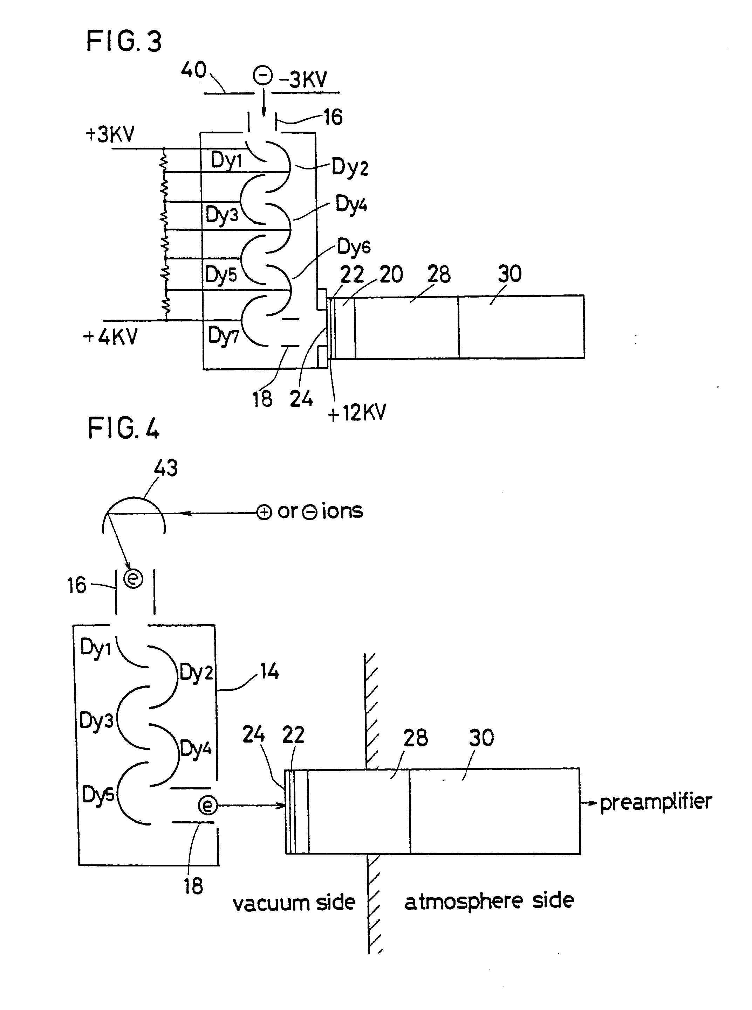

FIG. 3 shows a mass spectrometer utilizing the detector to detect minus ions. Voltages applied to the dynodes $Dy_1$ through $Dy_7$ of the secondary electron multiplier and the scintillator 22 are as follows by way of example: An acceleration voltage of minus ions passing through the collector slit 40 is assumed to be -3KV. A voltage of +3KV is applied to the first-stage dynode $Dy_1$ of the secondary electron multiplier 14 and a voltage of +4KV is applied to the last-stage dynode $Dy_7$. Voltages divided with the resistances are applied to the intermediate dynodes $Dy_2$ through $Dy_6$ as shown in FIG. 3. A voltage of +12KV is applied to the scintillator 22 through the metal layer 24 at the surface.

Since the deflector 16 is positioned at the entrance side of the secondary electron multiplier 14, an appropriate voltage is applied to the deflector 16 in order to detect charged particles, so that the incident charged particles can be directed to the first-stage dynode $Dy_1$, effectively. As some applied form, charged particles cannot be directed to the first-stage dynode by selecting a voltage applied to the deflector 16. In such a case, neutral particles only are incident upon the secondary electron multiplier 14, where the detector can be used to detect the neutral particles.

Since the deflector 18 is interposed between the last-stage dynode $Dy_7$ and the scintillator 22, the secondary electrons generated from the last-stage dynode $Dy_7$ are effectively introduced into the scintillator 22 by the deflector 18. By controlling a voltage applied to the deflector 18, the amount of the secondary electrons incident upon the scintillator 22 can be reduced to protect the scintillator 22.

When a voltage applied to the metal layer 24 at the surface of the scintillator 22 is higher than a voltage applied to the last-stage dynode $Dy_7$, the secondary electrons generated by the dynode $Dy_7$ are accelerated and directed to the scintillator 22, so that the intensity of light generated by the scintillator 22 increases and the gain becomes large.

The gain can be varied by changing voltages applied to the dynodes $Dy_1$ through $Dy_7$ of the secondary electron multiplier 14, or further by changing a voltage applied to the scintillator 22, so that the gain can be controlled by both the secondary electron multiplier 14 and the scintillator 22.

With the help of the light guide 28, as shown in FIG. 2, the secondary electron multiplier 14 and the scintillator 22 are positioned in a vacuum apparatus while the photomultiplier 30 is positioned at the atmosphere side, thus increasing the degree of freedom in designing the detector. Even when a high voltage is applied to the scintillator 22, any discharge can be prevented.

In the preferred embodiment of FIG. 1, the secondary electron multiplier 14 and the scintillator 22 are integrally combined. It may be possible that the scintillator 22, the light guide 28, and the photomultiplier 30 are integrally combined, with separating the secondary electron multiplier 14 therefrom.

FIG. 4 shows a preferred embodiment of the detector in which an ion-electron converter 43 is provided at the entrance side of the device of FIG. 1. The ion-electron converter 43 emits a number of secondary electrons when high-speed ions collide with it. It may comprise $A\ell$ or an alloy of Cu-Be or the like.

To detect plus ions by the mass spectrometer, the plus ions are normally accelerated with several KV. As minus several KV is applied to the ion-electron converter 43, the plus ions can collide against the surface of the ion-electron converter 43 at high speed to generate secondary electrons. The generated secondary electrons are effectively directed to the first-stage dynode $Dy_1$ with the deflector 16 at the entrance of the secondary electron multiplier 14. An appropriate voltage is applied to the first-stage dynode $Dy_1$ so that the dynode $Dy_1$ can collect the secondary electrons emitted by the ion-electron converter 43.

To detect minus ions by the mass spectrometer, the minus ions are accelerated with minus several KV while plus several KV is applied to the ion-electron converter 43.

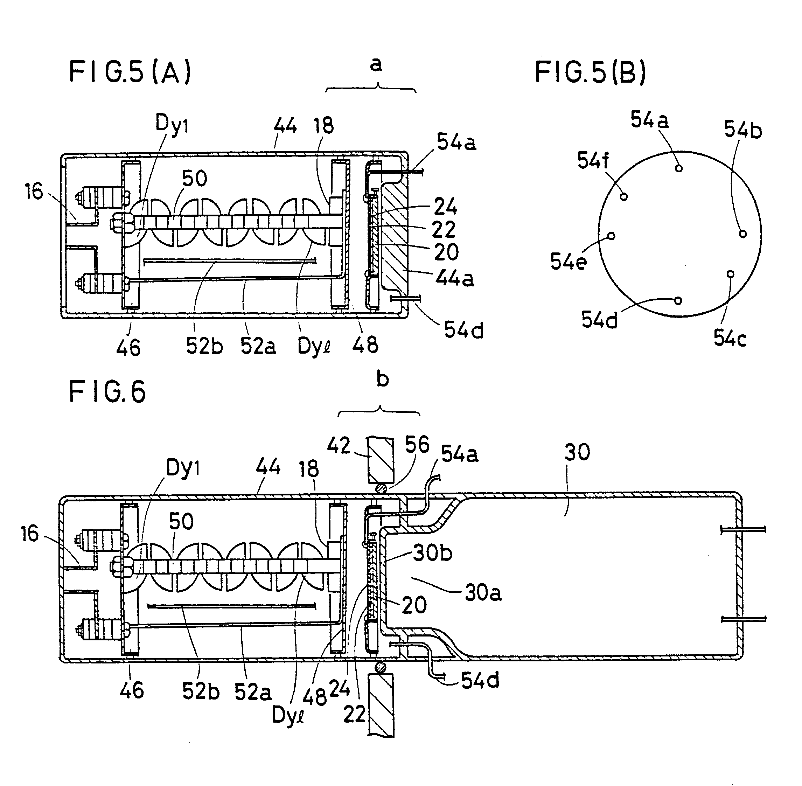

FIGS. 5(A) and 5(B) show a preferred embodiment of a detector in which the secondary electron multiplier and the scintillator are integrally combined within a cylindrical glass tube 44. FIG. 5(A) is a cross-sectional view and FIG. 5(B) is a right side view of FIG. 5(A).

An end of the cylindrical glass tube 44 (at the left side of FIG. 5(A)) is opened with the other end closed. At the closed end the scintillator 22 formed on the glass plate 20 is disposed. The metal layer 24 is formed on the scintillator 22 to apply a voltage. Between the scintillator 22 and the opening end of the cylindrical glass tube 44, two supporting rings 46 and 48 are provided. The interval between the two supporting rings 46 and 48 is defined with a support bar 50 covered with glass. A plurality of dynodes $Dy_1$ through $Dy\ell$ are provided between the two supporting rings 46 and 48. Appropriate voltages are applied to the dynodes $Dy$ through $Dy\ell$. Charged particles are incident upon the first stage dynode $Dy_1$ via the deflector 16. Secondary electrons emitted by the last-stage dynode $Dy\ell$ are incident upon the scintillator 22 via the deflector 18. Light emitted from the scintillator 22 passes through the glass plate 20 and a glass base plate 44a of the cylindrical glass tube 44 and can be taken out. Behind the glass base plate 44a (at the right side of FIG. 5(A)), a photomultiplier is provided via a light guide or directly. Lead wires 52a and 52b can serve to support the interval between the two supporting rings 46 and 48.

As shown in FIG. 5(B), lead wires 54a through 54f are taken out of holes of the glass base plate 44a. After the lead wires 54a through 54f are inserted, the holes are soldered so that when the inside of the cylindrical glass tube 44 is vacuumed, the vacuum condition may not leak. The lead wire 54a is to apply a voltage to the scintillator 22. The lead wire 54b is to apply a voltage to the deflector 16. The lead wire 54c is to apply a voltage to the first-stage dynode Dy₁. The lead wire 54d is to apply a voltage to the last-stage Dyℓ. The lead wire 54e is to apply a voltage to the deflector 18. The lead wire 54f is to apply a voltage to the supporting ring 48. These combinations may be changed.

FIG. 6 shows a preferred embodiment of a detector in which the photomultiplier 30 is integrally combined with the unit of FIG. 5 combining the secondary electron multiplier and the scintillator. In FIG. 6. the cylindrical glass tube 44 is opened at its base, in which opening a front edge 30a of the photomultiplier 30 is provided adjacent the glass plate 20 of the scintillator 22. No specific light guide is provided between the scintillator 22 and the photomultiplier 30. A glass plate 30b formed at the front edge 30a of the photomultiplier 30 can serve as a light guide. The cylindrical glass tube 44 is soldered with the container of the photomultiplier 30. The lead wires 54a through 54f are taken out of a side of the integrated cylindrical container. To attach the thus manufactured detector with the mass spectrometer, the detector is fixed to a side wall 42 of the vacuum apparatus via an O-ring 56. In FIG. 6, the left side is a vacuum side and the right side is an atmosphere side.

According to the preferred embodiment of FIG. 6 no specific light guide is disposed and the glass plate 30b formed at the front edge of the photomultiplier 30 serves as a light guide so as to prevent light transmission efficiency from being reduced at the light guide portion. Since the secondary electron multiplier, the scintillator and the photomultiplier are integrated, it becomes easier to replace the old detector with a new one.

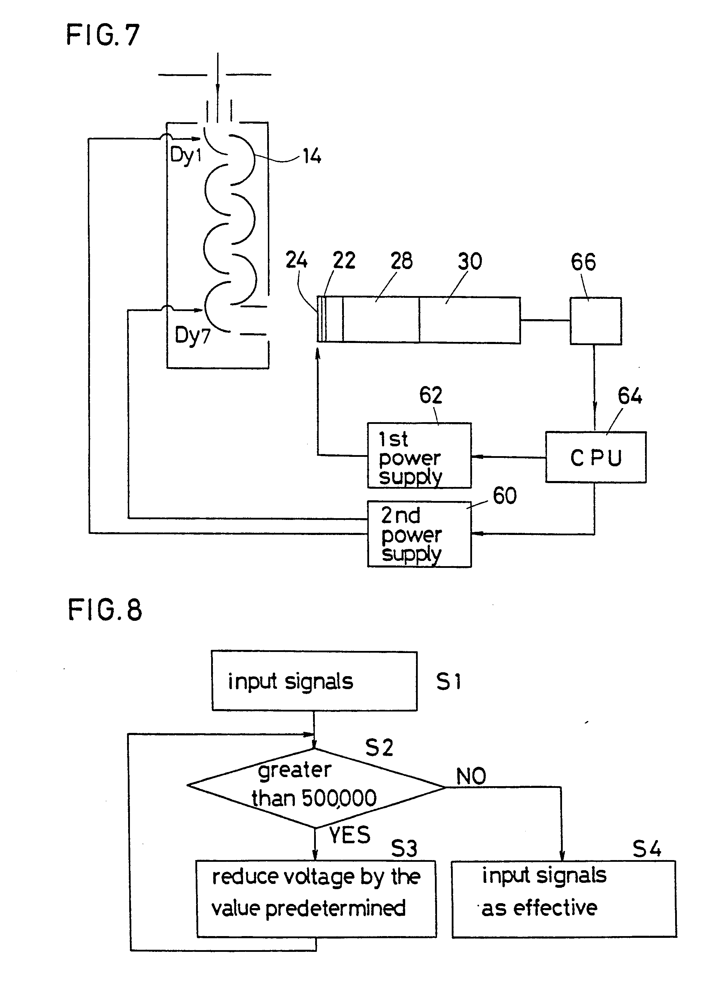

FIG. 7 shows the detector of FIG. 1 in which voltages applied to the dynodes Dy₁ through Dy₇ of the secondary electron multiplier 14 and a voltage applied to the scintillator 22 are controlled so as to expand the dynamic range of intensity measurement. The scintillator 22 may be integrated with the secondary electron multiplier 14 or, as shown in FIG. 7, may be independent of the multiplier 14.

A first power supply 60 is provided for applying voltages to the dynodes Dy₁ through Dy₇ of the secondary electron multiplier. A second power supply 62 is provided for applying a voltage to the scintillator 22 via the metal layer 24. A central processing unit (CPU) 64 is provided for controlling the first and the second power supplies 60 and 62 in response to output signals of an amplifier 66 amplifying the output signals of the photomultiplier 30. The control of the CPU 64 is as follows;

When the output signals of the amplifier 66 are about to be saturated, absolute values of the voltages applied to either the dynodes Dy₁ through Dy₇ or the scintillator 22, or the voltages applied to both the dynodes Dy₁ through Dy₇ and the scintillator 22 are reduced according to a predetermined control, so that the output signals of the amplifer 66 are prevented from being saturated.

FIG. 8 is a flow chart of the control with the CPU 64. At step S₁, the output signals of the amplifier 66 are inputted into the CPU 64. When the output signals of the amplifier 66 are greater than an intensity, for example 500,000, voltages applied to the dynodes Dy₁ through Dy₇ or applied to the scintillator 22 are reduced by a predetermined value at steps S₂ and S₃. When the output signals of the amplifier 66 are less than the intensity predetermined, the output signals of the amplifier 66 at that time are inputted into the CPU 64 together with the applied voltage as effective (step S₄).

FIG. 9 is a block diagram of a comparator 68 for controlling the voltages applied to the dynedes Dy₁ through Dy₇ and the scintillator 22. The output signals of the amplifier 66 are inputted into a non-reverse input terminal of the comparator 68 while a reference voltage Vr is inputted into a reverse input terminal of the comparator 68.

When the output signals of the amplifier 66 is greater than the reference voltage Vr, the output signals of the comparator 68 are conductive so that the first and the second power supplies 60 and 62 are operated to reduce the voltages applied to the dynodes Dy₁ through Dy₇ or the scintillator 22 by a predetermined value. Such operations are repeated until the output signals of the amplifier 66 become less than the reference voltage Vr.

In the above preferred embodiments, the secondary electron multiplier is provided as a multiplier. The number of the stages of the dynodes implemented within the secondary electron multiplier should not be limited to those as described in terms of the preferred embodiments. An additional secondary electron multiplier may be provided between the secondary electron multiplier and the scintillator. As a multiplier, a channeltron can replace the secondary electron multiplier.

In accordance with the present invention, the incident particles are converted into secondary electrons and the secondary electrons are amplified, so that the secondary electrons are incident upon the scintillator to be converted into light. The light is detected by the photomultiplier. Noise can be reduced to increase an S/N ration and sensitivity. The thus arranged detector can be used for a mass spectrometer.

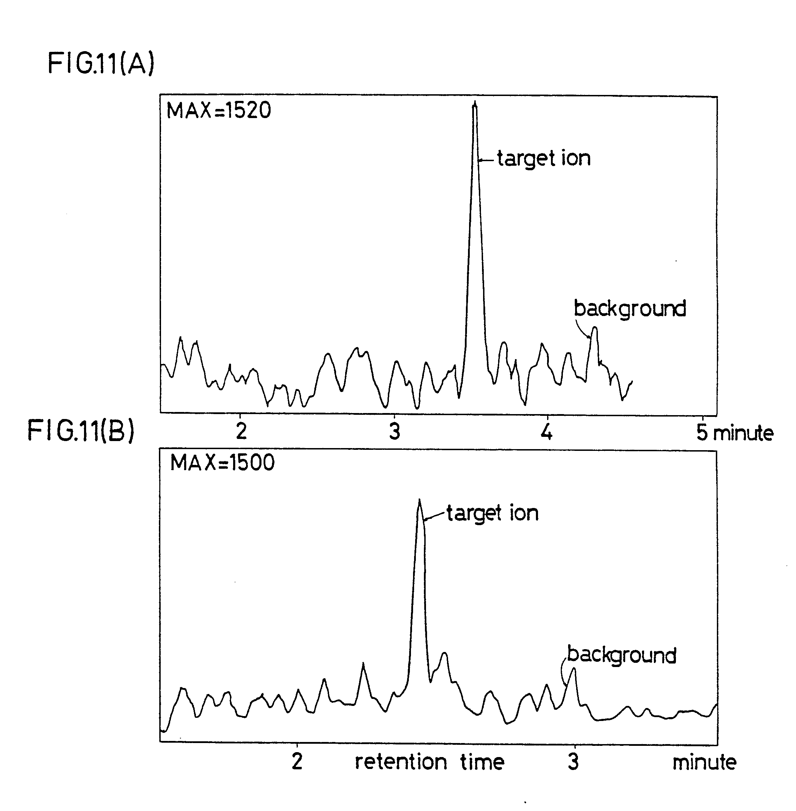

FIG.S 11(A) and 11(B) are data obtained by using mass fragmentarygraphy (MF) method in gas chromatography/mass spectrometry (GC/MS). FIG. 11(A) relates to a detector using the usual electron multiplier. FIG. 11(B) relates to a detector using the detector of the present invention as shown in FIG.

1. In the data of FIGS. 11(A) and 11(B), ions of 335 a.m.u. (atomic mass unit) decaying from the metastable ion of 448 (parent ion) a.m.u. are detected.

What is important in FIGS. 11(A) and 11(B) is that the amount of a sample ot be injected to the gas chromatography is about 3ng (=3000pg) for the data of FIG. 11(A) and that the amount of a sample to be injected to the gas chromatography according to the preffered embodiment is about 100pg. Thus, according to the present invention, the sensibility is about 20 times as large as the conventional case.

While only certain embodiments of the present invention have been described, it will be apparant to those skilled in the art that various changes and modifications may be made therein without departing from the spirit and scope of the present invention as claimed.

## Claims

1. A detector for detecting charged particles, comprising:
secondary electron multiplier means (14) for converting the charged particles into secondary electrons and amplifying the secondary electrons;
scintillator means (22) for converting said secondary electrons generated from said secondary electron multiplier means into light; and
photomultiplier means (30) for receiving said light.

2. The detector of claim 1, wherein said secondary electron multiplier means (14) comprises an entrance (14a) upon which said charged particles are incident and an exit (14b) through which said secondary electrons generated in said secondary electron multiplier means (14) are taken out, and a plurality of dynodes ($D_{y1}$ -$D_{y7}$) arranged between said entrance (14 a) and said exit (14 b).

3. The detector of claim 1, wherein said scintillator means (22) comprises the thin metal layer means (24) on its surface, to which a voltage is applied so that said secondary electrons ejected through said exit (14b) of said secondary electron multiplier means (14) are accelerated and directed to said scintillator means (22).

4. The detector of claim 1, further comprising deflector means (16) adjacent said entrance (14 a) of said secondary electron multiplier means (14) for directing said charged particles incident into said secondary electron multiplier means (14).

5. The detector of claim 1, further comprising second deflector means (18) between either the last-stage dynode means ($D_{y7}$) or said exit (14 b) and said scintillator means (22) for directing said secondary electrons ejected from said exit (14 b) into said scintillator means (22).

6. The detector of claim 1, further comprising light guide means (28) interposed between said scintillator means (22) and said photomultiplier means (30).

7. The detector of claim 1, wherein said secondary electron multiplier means (14) and said scintillator means (22) are integrated.

8. The detector of claim 1, wherein said secondary electron multiplier means (14), said scintillator means (22), and said photomultiplier means (30) are integrated.

9. The detector of claim 1, wherein said secondary electron multiplier means (14) is covered with a shield.

# FIG.1

incident particles

16 deflector

14a

Dy1   Dy2

14 secondary electron multiplier

Dy3   Dy4

Dy5   Dy6

14b   30 photomultiplier

Dy7

deflector 18   24   20   28 light guide

26

22 scintillator

Shimadzu Corp.
EPC8605SH

## FIG.2

+3KV

-4KV

Dy1

Dy2

16

14

Dy3 Dy4

Dy5 Dy6

Dy7

-3KV

40

42

22

20

28

30

→ preamplifier

18 24

+5KV

vacuum side

34

32

atmosphere side

38

36

## FIG. 3

40 $\ominus$ −3KV

16

+3KV

Dy1  Dy2

Dy3  Dy4

Dy6

Dy5  22 20 28 30

+4KV  Dy7

18 24 +12KV

## FIG. 4

43

$\oplus$ or $\ominus$ ions

16  $\textcircled{e}$

Dy1
Dy2  14
Dy3
Dy4

24 22 28 30
Dy5  $\textcircled{e}$ → preamplifier

18

vacuum side  atmosphere side

FIG.5(A)

FIG.5(B)

FIG.6

## FIG.7

## FIG.8

# FIG.9

# FIG.10

Shimadzu Corp.
EPC8605SH

## FIG.11(A)

MAX=1520

—target ion

background

2          3          4          5 minute

## FIG.11(B)

MAX=1500

target ion

background

2          retention time          3          minute

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | REV. SCI. INSTRUM., vol. 49, no. 9, September 1978, pages 1250-1256, American Institute of Physics, New York, US; L.A. DIETZ et al.: "Electron multiplier-scintillator detector for pulse counting positive or negative ions" * Page 1250, column 2, line 24 - page 1251, column 1, line 19; column 2, lines 10-20,28-37; figures 1,2 with captions * | 1-9 | G 01 T 1/28 |
| | --- | | |
| X | GB-A-2 039 140 (KRATOS LTD) * Page 1, line 121 - page 2, line 36; figure * | 1-4,6-8 | |
| A | ----- | 5 | **TECHNICAL FIELDS SEARCHED (Int. Cl.4)** G 01 T H 01 J |

The present search report has been drawn up for all claims

| Place of search | Date of completion of the search | Examiner |
|---|---|---|
| THE HAGUE | 23-09-1987 | DATTA S. |